# EUROPEAN PATENT SPECIFICATION

(11) **EP 4 637 281 B1**
(45) Date of publication and mention of the grant of the patent: **12.08.2026**
(21) Application number: 24198359.2
(22) Date of filing: 04.09.2024
(51) Int. Cl.: H05K 5/06

(54) **SEALED HOUSING, INVERTER AND ELECTRIC POWER SYSTEM**
ABGEDICHTETES GEHÄUSE, WECHSELRICHTER UND ELEKTRISCHES STROMVERSORGUNGSSYSTEM
BOÎTIER ÉTANCHE, ONDULEUR ET SYSTÈME D'ALIMENTATION ÉLECTRIQUE

(30) Priority: 15.04.2024 CN 202420777034 U
(43) Date of publication of application: 22.10.2025
(73) Proprietor: Sungrow (Shanghai) Co., Ltd., Shanghai 201203 (CN)
(72) Inventor: QIAO, Kai, Shanghai, 201203 (CN); ZHANG, Jialiang, Shanghai, 201203 (CN); ZHAO, Bo, Shanghai, 201203 (CN)
(74) Representative: Rooney, John-Paul

(56) References cited:
- US-A1- 2019 380 220
- US-A1- 2020 236 797

## Description

### FIELD

The present application relates to the technical field of electrical technologies, and in particular to a sealed housing, an inverter and an electric power system. An example of a sealed housing is disclosed by the document US2019/380220, Matsuda Yusuke, published on 12 December 2019.

### BACKGROUND

An inverter is generally exposed to the environment. For example, a microinverter is usually deployed outdoors even in wilderness, and is operated in a complex environment. In order to improve the waterproof and dustproof performances of the inverter, a sealant is usually provided at a joint face between two housings of the housing structure of the inverter.

The amount of the applied sealant cannot be controlled precisely. The sealant may be squeezed to an outer surface of the housing structure, thereby requiring additional processes of detecting and removing the overflowed sealant on the outer surface of the housing, so as to ensure the appearance of the product. As a result, the production efficiency of the inverter is affected.

### SUMMARY

An object of the present application is to solve a problem in the prior art that a sealant at a joint face between an upper housing and a lower housing of a sealed housing overflows to an outer surface of a housing structure.

In a first aspect, a sealed housing is provided according to the present application, including an upper housing and a lower housing, where
the lower housing is provided with a sealing groove extending along a peripheral direction of the lower housing, and the upper housing is provided with a sealing plate corresponding to the sealing groove;
a sealant is provided inside the sealing groove, and the sealing plate extends into the sealant;
an outer sealant cavity and an inner sealant cavity are formed at both sides of the sealing plate respectively inside the sealing groove, and a mounting cavity is defined by the upper housing and the lower housing;
the outer sealant cavity is provided with an outer overflow portion, and the inner sealant cavity is provided with an inner overflow portion; and
the sealing groove and the sealing plate are configured to make a resistance loss corresponding to the outer sealant cavity be higher than a resistance loss corresponding to the inner sealant cavity, where the resistance loss refers to mechanical energy consumed by the sealant per unit weight when flowing to reach the corresponding overflow portion through the corresponding sealant cavity.

In an embodiment, a minimum size of the outer sealant cavity in a width direction of the sealing groove is smaller than a minimum size of the inner sealant cavity in the width direction of the sealing groove.

In an embodiment, at least one of the sealing groove and the sealing plate is provided with a sealant blocking structure at the outer sealant cavity.

In an embodiment, the sealant blocking structure includes a height-set section, and in the height-set section, a surface of the sealant blocking structure in the width direction of the sealing groove is arranged obliquely upward; and/or
when a lower surface of the sealing plate is fitted to an inner bottom face of the sealing groove, a lower end of the sealant blocking structure is spaced apart from the inner bottom face of the sealing groove; and/or
when the lower surface of the sealing plate is fitted to the inner bottom face of the sealing groove, an upper end of the sealant blocking structure is spaced apart from the outer overflow portion in an up-down direction.

In an embodiment, a length of a path along which the sealant flows to reach the outer overflow portion for overflow through the outer overflow portion of the outer sealant cavity is greater than or equal to a length of a path along which the sealant flows to reach the inner overflow portion for overflow through the inner overflow portion of the inner sealant cavity.

In an embodiment, the path, along which the sealant flows to reach the outer overflow portion for overflow through the outer overflow portion of the outer sealant cavity, includes at least one of an inclined path segment and a curved path segment.

In an embodiment, an inner surface of an outer groove wall of the sealing groove includes at least one of an inclined segment and a curved segment in the up-down direction; in a case that the inclined segment is provided, the inner surface of the outer groove wall of the sealing groove is arranged obliquely upward at least in a portion where the inclined segment is located.

In an embodiment, the outer overflow portion is higher than or flush with the inner overflow portion in the up-down direction; and/or
a top face of the outer groove wall of the sealing groove forms the outer overflow portion; and/or
a top face of an inner groove wall of the sealing groove forms the inner overflow portion.

In an embodiment, at least one of the sealing groove and the sealing plate is provided with a recessed structure.

In an embodiment, the recessed structure includes at least one of a first recessed portion, a second recessed portion, a third recessed portion, and a fourth recessed portion; where the first recessed portion is provided at an outer edge of a lower end of the sealing plate, the second recessed portion is provided at an inner edge of the lower end of the sealing plate, the third recessed portion is provided on the inner groove wall of the sealing groove, and the fourth recessed portion is provided on the outer groove wall of the sealing groove; and/or
the recessed structure extends along an extension direction of the sealing groove.

In an embodiment, at least one of the sealing groove and the sealing plate is provided with a rough texture at a portion corresponding to the outer sealant cavity; and/or
the sealed housing further includes an insertion positioning structure, and the upper housing and the lower housing are positionally connected through the insertion positioning structure; and/or
at least one of the upper housing and the lower housing is provided with a filling hole, and the filling hole configured through which an adhesive is filled into the mounting cavity.

In a second aspect of the present application, an inverter is provided, including the sealed housing according to the above first aspect.

In a third aspect of the present application, an electric power system is provided, including the sealed housing according to the above first aspect, or the inverter according to the above second aspect.

Compared with the related prior art, in the sealed housing, the inverter, and the electric power system according to the present application, the sealant can be preliminary positioned by the sealing groove provided at the lower housing, then the sealing plate of the upper housing is inserted into the sealant, and the outer sealant cavity and the inner sealant cavity are formed at the both sides of the sealing plate inside the sealing groove. To be more specific, along the width direction of the sealing groove, the space between the inner surface of the outer groove wall of the sealing groove and the outer surface of the sealing plate is defined as the outer sealant cavity, and the space between an inner surface of the inner groove wall of the sealing groove (i.e. a surface of the inner groove wall close to the sealing plate) and an inner surface of the sealing plate is defined as the inner sealant cavity. Under an extrusion effect of the sealing plate, part of the sealant overcomes a resistance provided by the outer sealant cavity and moves towards the outer overflow portion, and another part of the sealant overcomes a resistance provided by the inner sealant cavity and moves towards the inner overflow portion. In this case, the outer sealant cavity and the inner sealant cavity may be respectively regarded as a pipe. With the structures of the sealing groove and the sealing plate, the resistance loss corresponding to the outer sealant cavity is higher than the resistance loss corresponding to the inner sealant cavity, where the resistance loss corresponding to the outer sealant cavity refers to the mechanical energy consumed by the sealant per unit weight when flowing to reach the outer overflow portion through the outer sealant cavity, and the resistance loss corresponding to the inner sealant cavity refers to the mechanical energy consumed by the sealant per unit weight when flowing to reach the inner overflow portion through the inner sealant cavity. In this way, it is harder for the sealant to overflow through the outer sealant cavity than through the inner sealant cavity. Even if the amount of the sealant is so large that there may be a risk of overflow, the sealant will overflow through a path that makes it easier to flow out, that is, the sealant is more likely to overflow out of the inner overflow portion through the inner sealant cavity. Therefore, the sealant is less possible to overflow to an outer surface of the upper housing and the lower housing through the outer overflow portion, and the amount of the overflowed sealant is reduced, which improves the production efficiency of the sealed housing on the premise of ensuring the sealing performance between the upper housing and the lower housing.

### BRIEF DESCRIPTION OF THE DRAWINGS

FIG. 1 is a schematic exploded view showing the structure of a sealed housing according to a first embodiment of the present application;
FIG. 2 is a schematic sectional view showing an upper housing and a lower housing of the sealed housing being connected according to the first embodiment of the present application;
FIG. 3 is a schematic sectional view showing an upper housing and a lower housing of a sealed housing being connected according to a second embodiment of the present application;
FIG. 4 is a schematic sectional view showing an upper housing and a lower housing being connected according to a third embodiment of the present application where a sealant blocking structure includes a height-set section;
FIG. 5 is a schematic sectional view showing an upper housing and a lower housing being connected according to a fourth embodiment of the present application where both an inner surface of an outer groove wall of a sealing groove and an outer surface of a sealing plate are obliquely arranged;
FIG. 6 is a schematic sectional view showing an upper housing and a lower housing being connected according to a fifth embodiment of the present application where each of an inner surface of an outer groove wall of a sealing groove and an outer surface of a sealing plate includes a curved segment;
FIG. 7 is a schematic sectional view showing an upper housing and a lower housing being connected according to a sixth embodiment of the present application;
FIG. 8 is a schematic sectional view showing an upper housing and a lower housing being connected according to a seventh embodiment of the present application; and
FIG. 9 is a schematic sectional view showing an upper housing and a lower housing being connected according to an eighth embodiment of the present application.

### Reference numerals:

| | | | |
|---|---|---|---|
| 1 | upper housing, | 11 | sealing plate, |
| 2 | lower housing, | 21 | sealing groove, |
| 211 | outer groove wall, | 211A | inclined segment, |
| 211B | curved segment, | 212 | inner groove wall, |
| 213 | inner bottom face, | 3 | outer sealant cavity, |
| 31 | outer overflow portion, | 4 | inner sealant cavity, |
| 41 | inner overflow portion, | 5 | mounting cavity, |
| 6 | sealant blocking structure, | 61 | height-set section, |
| 7 | recessed structure, | 71 | first recessed portion, |
| 72 | second recessed portion, | 73 | third recessed portion, |
| 74 | fourth recessed portion, | 8 | sealant, |
| 9 | cable assembly. | | |

### DETAILED DESCRIPTION OF THE EMBODIMENTS

Specific embodiments of the present application will be described clearly and completely as follows in conjunction with the accompany drawings, so that purposes, characteristics and advantages of the present application can be more obvious and understandable.

In the description of the present application, it should be noted that, unless otherwise clearly specified and limited, the terms "mount", "connected to" and "connection" should be understood in a broad sense. For example, it may be a fixed connection, a detachable connection, or an integral connection; it may be a direct connection, or an indirect connection through an intermediate medium. For those skilled in the art, the specific meanings of the above terms in the present application may be understood according to specific situations.

In the description of this specification, descriptions referring to the terms "embodiment", "one embodiment", "some solutions", "in an example", "one solution", etc., mean that specific features, structures, materials or characteristics described in conjunction with the embodiment or solution are included in at least one embodiment or solution of the present application. In this specification, schematic expressions of the above terms do not necessarily refer to the same embodiment or solution. Furthermore, the specific features, structures, materials or characteristics described may be combined in any suitable manner in any one or more embodiments or solutions.

The terms such as "first", "second" and the like are merely for description, and should not be construed as indicating or implying relative importance, or implicitly indicating the number of technical features being referred to. In this way, the feature defined by the terms "first", "second" may explicitly or implicitly include at least one such features.

In the drawings, the Z-axis denotes a vertical direction, i.e. an up-down direction, where a positive direction (i.e. a direction indicated by an arrow of the Z-axis) of the Z-axis indicates an upper side, and a negative direction of the Z-axis indicates a lower side. The X-axis denotes a front-rear direction, where a positive direction (i.e. a direction indicated by an arrow of the X-axis) of the X-axis indicates a front side, and a negative direction of the X-axis indicates a rear side. The Y-axis denotes a horizontal direction, which is referred to as a left-right direction, where a positive direction (i.e. a direction indicated by an arrow of the Y-axis) of the Y-axis indicates a right side, and a negative direction of the Y-axis indicates a left side. It should also be noted that, the meanings of the Z-axis, Y-axis and X-axis described hereinabove are merely for the convenience of describing the present application and simplifying the description, and do not indicate or imply that the device or element referred to must have a particular orientation, or be configured and operated in a particular orientation, which therefore should not be construed as a limitation to the scope of the present application.

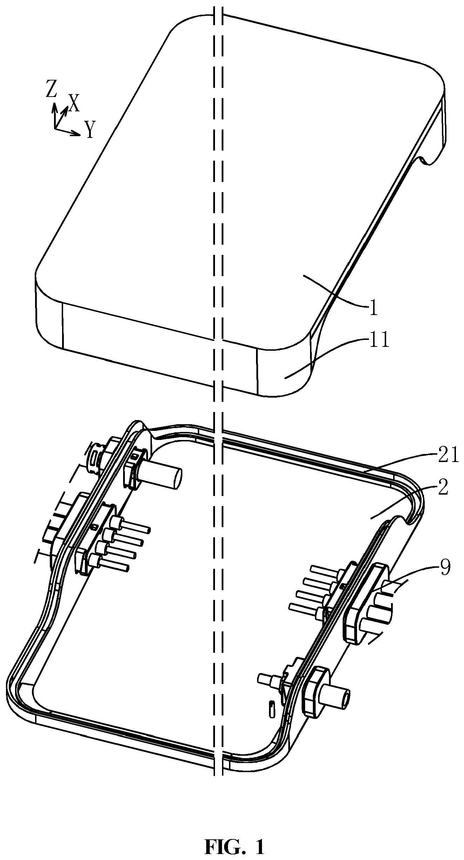

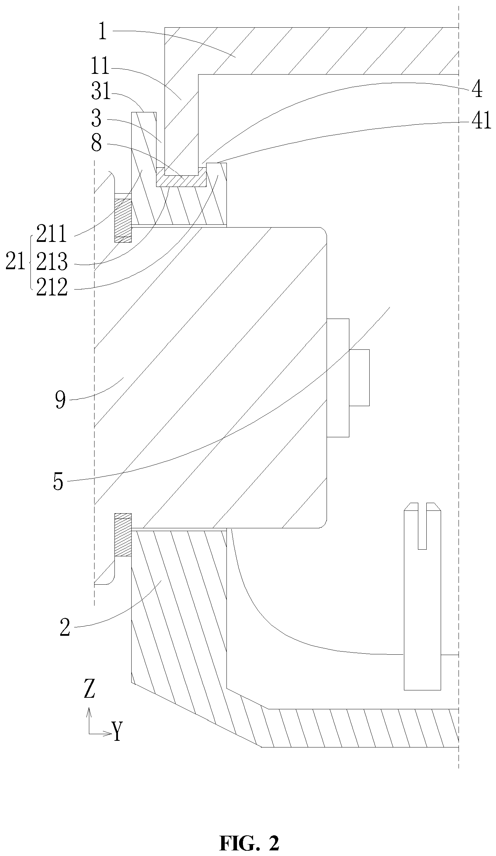

As shown in FIGS. 1 and 2, a sealed housing is provided according to the present application. The sealed housing includes an upper housing 1 and a lower housing 2, the lower housing 2 is provided with a sealing groove 21 extending along a peripheral direction of the lower housing 2, and the upper housing 1 is provided with a sealing plate 11 corresponding to the sealing groove 21. A sealant 8 is provided inside the sealing groove 21, and the sealing plate 11 extends into the sealant 8. An outer sealant cavity 3 and an inner sealant cavity 4 are formed at both sides of the sealing plate 11 respectively inside the sealing groove 21. The outer sealant cavity 3 and the inner sealant cavity 4 are provided with an outer overflow portion 31 and an inner overflow portion 41 respectively. The sealing groove 21 and the sealing plate 11 are configured to make a resistance loss corresponding to the outer sealant cavity 3 be higher than a resistance loss corresponding to the inner sealant cavity 4, where the resistance loss refers to mechanical energy consumed by the sealant 8 per unit weight when flowing to reach the corresponding overflow portion through the corresponding sealant cavity.

Specifically, the sealing groove 21 extends along the peripheral direction of the lower housing 2, and forms a loop-shaped groove with two ends thereof being connected. Correspondingly, the sealing plate 11 extends along a peripheral direction of the upper housing 1. A projection of the sealing groove 21 on a horizontal plane (a plane parallel to the XY plane) is of a loop shape, which may be rectangular or circular, and provided according to actual needs. Moreover, portions of the sealing groove 21 along an extension direction thereof may be different in height in the up-down direction, which is determined according to actual needs and is not limited herein. Specifically, portions of an inner bottom face of the sealing groove 21 along an extension direction thereof may be different in height.

As shown in FIGS. 1 and 2, the upper housing 1 is located on top of the lower housing 2, and the upper housing 1 and the lower housing 2 come together to form a mounting cavity 5, and thus a relatively complete housing structure is formed. Components such as a circuit board assembly of an inverter and the like are mounted inside the mounting cavity 5. In this specification, the description of the "upper" housing 1 and the "lower" housing 2 are merely intended to indicate positions of the two housings in the up-down direction when they are being connected through the sealant 8. In actual use, the upper housing 1 is not necessarily located on top of the lower housing 2. For example, the upper housing 1 and the lower housing 2 may be distributed in sequence along a horizontal direction, which is not described in detail hereinafter.

It should be understood that, the sealing requirement at the joint between the upper housing 1 and the lower housing 2 can be satisfied as long as an inner bottom face 213 of the sealing groove 21 and a lower surface of the sealing plate 11 are connected through the sealant 8 to form a sealing face. However, the amount of the sealant 8 can hardly be controlled precisely, or from another perspective, the cost of precise control thereof is relatively high. Generally, excess amount of the sealant 8 is provided for forming the sealing face, and during the process that the sealing plate 11 extends into the sealant 8 to contact the inner bottom face 213 of the sealing groove 21, due to the downward pressing of the sealing plate 11, the excess sealant 8 flows towards an inner side and an outer side of the sealing face under extrusion. As a result, there is a risk that the excess sealant 8 flows to an outer surface of the upper housing 1 and an outer surface of the lower housing 2.

When the upper housing 1 and the lower housing 2 are being connected, the lower housing 2 is placed flat first, such that the inner bottom face 213 of the sealing groove 21 is substantially parallel to the XY-plane. Then the sealant 8 is put into the sealing groove 21, where a depth of the sealant 8 inside the sealing groove 21 is determined according to the actual situation. For example, the depth of the sealant layer may be in a range from 0.1 to 1.5 mm, or in a range from 0.4 to 1 mm. Then, the sealing plate 11 of the upper housing 1 is aligned with the sealing groove 21, and the upper housing 1 moves downwards, the lower surface of the sealing plate 11 comes into contact with the sealant 8 and applies a pressure to the sealant 8. When being pressed, the sealant 8 moves towards the inner side and the outer side along a width direction of the sealing groove 21 (where the width direction is perpendicular to the up-down direction and perpendicular to the extension direction of the sealing groove 21 in the horizontal plane). During this process, a space between an outer surface of the sealing plate 11 (i.e., a surface close to an exterior of the sealed housing in the width direction of the sealing groove 21, which is not described in detail hereinafter) and an inner surface of an outer groove wall 211 of the sealing groove 21 forms the outer sealant cavity 3, and another space between an inner surface of the sealing plate 11 (i.e., a surface close to an interior of the sealed housing in the width direction of the sealing groove 21, which is not described in detail hereinafter) and an inner surface of an inner groove wall 212 of the sealing groove 21 forms the inner sealant cavity 4. The sealant 8 under pressure flows to the outer sealant cavity 3 and the inner sealant cavity 4 along the width direction of the sealing groove 21.

Herein, the sealant 8 is relatively viscous. For example, in the present embodiment, the sealant 8 employs a one-component room-temperature-vulcanizing silicone with a viscosity ranging from 50000 to 70000 mPa·s. When flowing towards the outer overflow portion 31 through the outer sealant cavity 3, the sealant 8 is in contact with the surfaces forming the outer sealant cavity 3 (i.e., the outer surface of the sealing plate 11 and the inner surface of the outer groove wall 211 of the sealing groove 21), and there's a resistance loss. During this process, the sealant 8 flowing through the outer sealant cavity 3 may be regarded as flowing through a pipe, and the resistance loss may be approximately regarded as a pipe resistance loss. Specifically, the resistance loss corresponding to the outer sealant cavity 3 refers to mechanical energy consumed by the sealant 8 per unit weight when flowing to reach the outer overflow portion 31 through the outer sealant cavity 3. Correspondingly, the resistance loss corresponding to the inner sealant cavity 4 refers to mechanical energy consumed by the sealant 8 per unit weight when flowing to reach the inner overflow portion 41 through the inner sealant cavity 4. With the structures of the sealing groove 21 and the sealing plate 11, the resistance loss corresponding to the outer sealant cavity 3 is higher than the resistance loss corresponding to the inner sealant cavity 4. Under the action of the resistance losses, it is harder for the sealant 8 to overflow through the outer overflow portion 31 of the outer sealant cavity 3 than through the inner overflow portion 41 of the inner sealant cavity 4.

In this way, the sealant 8 can be initially positioned by the sealing groove 21 provided at the lower housing 2. Then the sealing plate 11 of the upper housing 1 is inserted into the sealant 8, and the outer sealant cavity 3 and the inner sealant cavity 4 are formed at the both sides of the sealing plate 11 inside the sealing groove 21. To be more specific, along the width direction of the sealing groove 21, the space between the inner surface of the outer groove wall 211 of the sealing groove 21 and the outer surface of the sealing plate 11 forms the outer sealant cavity 3, and the another space between the inner surface of the inner groove wall 212 of the sealing groove 21 (i.e. the surface close to the sealing plate 11) and the inner surface of the sealing plate 11 forms the inner sealant cavity 4. Under the extrusion effect of the sealing plate 11, a part of the sealant 8 overcomes a resistance caused by the outer sealant cavity 3 and moves towards the outer overflow portion 31, and another part of the sealant 8 overcomes a resistance caused by the inner sealant cavity 4 and moves towards the inner overflow portion 41. In this case, the outer sealant cavity 3 and the inner sealant cavity 4 may be regarded as pipes. With the structures of the sealing groove 21 and the sealing plate 11, the resistance loss corresponding to the outer sealant cavity 3 is higher than the resistance loss corresponding to the inner sealant cavity 4, where the resistance loss corresponding to the outer sealant cavity 3 refers to the mechanical energy consumed by the sealant 8 per unit weight when flowing to reach the outer overflow portion 31 through the outer sealant cavity 3, and the resistance loss corresponding to the inner sealant cavity 4 refers to the mechanical energy consumed by the sealant 8 per unit weight when flowing to reach the inner overflow portion 41 through the inner sealant cavity 4. In this way, it is harder for the sealant 8 to overflow through the outer sealant cavity 3 than through the inner sealant cavity 4, and even if the amount of the sealant 8 is so large that there may be a risk of overflow, the sealant 8 will overflow through a path that makes it easier to flow out. That is to say, the sealant 8 is more likely to overflow out of the inner overflow portion 41 through the inner sealant cavity 4. Therefore, the sealant 8 is less possible to overflow to the outer surface of the upper housing 1 and the lower housing 2 through the outer overflow portion 31, and the amount of the overflowed sealant 8 is reduced, which improves the production efficiency of the sealed housing is improved on the premise of ensuring the sealing performance between the upper housing 1 and the lower housing 2.

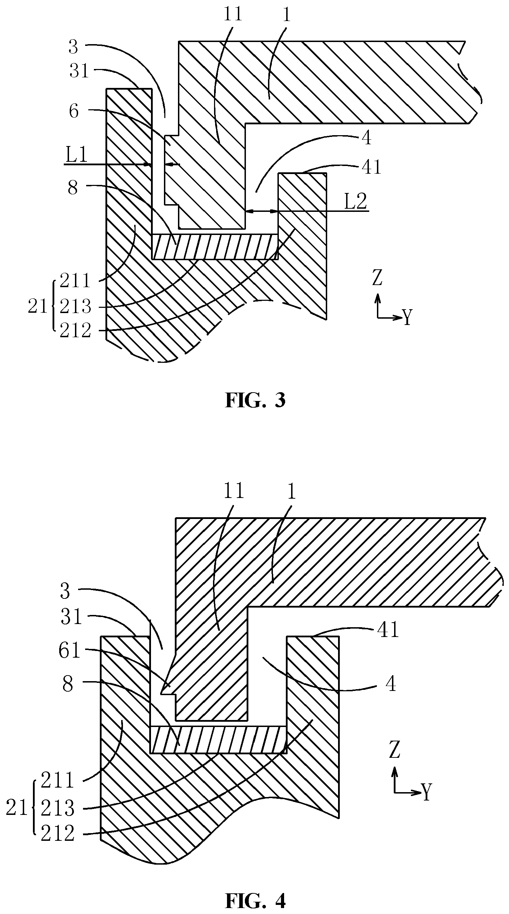

As shown in FIG. 3, in an embodiment, a minimum size of outer sealant cavity 3 in the width direction of the sealing groove 21 is smaller than a minimum size of the inner sealant cavity 4 in the width direction of the sealing groove 21.

The minimum size of the outer sealant cavity 3 may refer to L1 in FIG. 3, and the minimum size of the inner sealant cavity 4 may refer to L2 in FIG. 3. L1 is smaller than L2, such that the sealant 8 loses more mechanical energy when passing through a portion of the outer sealant cavity 3 having the minimum size thereof than through a portion of the inner sealant cavity 4 having the minimum size thereof, thereby increasing the resistance loss corresponding to the outer sealant cavity 3 to some degree.

It may be appreciated that, the way in which the outer sealant cavity 3 is provided with the minimum size thereof and the way in which the inner sealant cavity 4 is provided with the minimum size thereof are not limited.

In an embodiment, the sealed housing further includes an insertion positioning structure, and the upper housing 1 and the lower housing 2 are positionally connected through the insertion positioning structure.

With the insertion positioning structure, the upper housing 1 and the lower housing 2 are connected in the up-down direction at preset positions and postures, thereby improving the stability of the values of the above two minimum sizes.

In some cases, a protrusion is provided on the outer surface of the sealing plate 11 in the width direction, such as on a surface of a sealant blocking structure 6 of the sealing plate 11 in the width direction of the sealing groove 21 as described hereinafter. The protrusion abuts against the inner surface of the outer groove wall 211 of the sealing groove 21, such that the upper housing 1 and the lower housing 2 are relatively positioned.

In an embodiment, at least one of the sealing groove 21 and the sealing plate 11 is provided with a sealant blocking structure 6 at the outer sealant cavity 3.

FIG. 3 shows a case that the sealant blocking structure 6 is provided on the outer surface of the sealing plate 11. Alternatively, the sealant blocking structure 6 may be provided on the inner surface of the outer groove wall 211 of the sealing groove 21.

With the sealant blocking structure 6, the outer sealant cavity 3 has a relatively small size in the width direction of the sealing groove 21 at a position where the sealant blocking structure 6 is located. For example, the outer sealant cavity 3 has the minimum size thereof at the sealant blocking structure 6, such that the resistance loss corresponding to the outer sealant cavity 3 is increased.

As shown in FIG. 3, in an embodiment, when the lower surface of the sealing plate 11 is fitted to the inner bottom face 213 of the sealing groove 21, a lower end of the sealant blocking structure 6 is spaced apart from the inner bottom face 213 of the sealing groove 21.

With this arrangement, on the basis of increasing the resistance loss corresponding to the outer sealant cavity 3, a portion of the outer sealant cavity 3 at the lower end of the sealant blocking structure 6 ensures a performance of the outer sealant cavity 3 to accommodate the sealant 8, reduces the impact on the performance of the outer sealant cavity 3 to accommodate the sealant 8 caused by the sealant blocking structure 6, and reduces a possibility that the sealant 8 overflows through the outer overflow portion 31.

As shown in FIG. 3, in an embodiment, when the lower surface of the sealing plate 11 is fitted to the inner bottom face 213 of the sealing groove 21, an upper end of the sealant blocking structure 6 is spaced apart from the outer overflow portion 31 in the up-down direction.

Similarly, with this arrangement, on the basis of increasing the resistance loss corresponding to the outer sealant cavity 3, a portion of the outer sealant cavity 3 at the upper end of the sealant blocking structure 6 ensures the performance of the outer sealant cavity 3 to accommodate the sealant 8, reduces the impact on the performance of the outer sealant cavity 3 to accommodate the sealant 8 caused by the sealant blocking structure 6, and reduces the possibility that the sealant 8 overflows through the outer overflow portion 31.

As shown in FIG. 4, in a further solution of the sealant blocking structure 6, the sealant blocking structure 6 includes a height-set section 61. In the height-set section 61, a surface of the sealant blocking structure 6 in the width direction of the sealing groove 21 is arranged obliquely upward.

FIG. 4 shows a case that the sealant blocking structure 6 only includes the height-set section 61. In this case, the outer sealant cavity 3 has the minimum size thereof in the width direction of the sealing groove 21 at a bottom end of the height-set section 61. The surface of the sealant blocking structure 6 in the width direction of the sealing groove 21 is arranged obliquely upward, that is, from bottom to top, a distance between an outer surface of the sealant blocking structure 6 and the outer surface of the sealing plate 11 gradually increases, where the outer surface of the sealant blocking structure 6 refers to the surface close to the exterior of the sealed housing in the width direction of the sealing groove 21. In this way, within the set height, a size of the outer sealant cavity 3 in the width direction of the sealing groove 21 gradually increases from bottom to top, so as to ensure the performance of the outer sealant cavity 3 to accommodate the sealant 8 on the basis of increasing the resistance loss corresponding to the outer sealant cavity 3, which reduces the possibility that the sealant 8 overflows through the outer overflow portion 31.

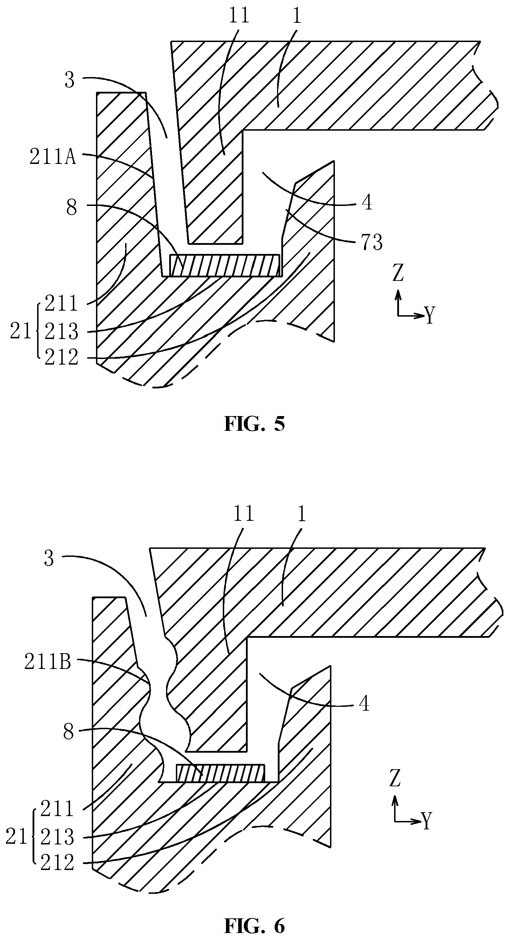

As shown in FIG. 5, in a solution of the present application, a length of a path along which the sealant 8 flows to reach the outer overflow portion 31 for overflow through the outer overflow portion 31 of the outer sealant cavity 3 is greater than or equal to a length of a path along which the sealant 8 flows to reach the inner overflow portion 41 for overflow through the inner overflow portion 41 of the inner sealant cavity 4.

The way of making the length of the path of the sealant 8 flowing to reach the outer overflow portion 31 for overflow through the outer overflow portion 31 of the outer sealant cavity 3 greater is not limited. For example, the path of the sealant 8 flowing to reach the outer overflow portion 31 for overflow through the outer overflow portion 31 of the outer sealant cavity 3 includes at least one of an inclined path segment and a curved path segment, so as to increase the length of the path for overflow through the outer overflow portion 31 of the outer sealant cavity 3.

In this way, with the arrangement of the length of the path for overflow, the sealant 8 encounters a larger resistance loss when overflowing through the outer overflow portion 31 of the outer sealant cavity 3. Therefore, the sealant 8 is less likely to overflow through the outer overflow portion 31 of the outer sealant cavity 3.

In an embodiment, the inner surface of the outer groove wall 211 of the sealing groove 21 includes at least one of an inclined segment 211A and a curved segment 211B in the up-down direction, and in a case that the inclined segment 211A is provided or both the inclined segment 211A and the curved segment 211B are provided, the inner surface of the outer groove wall 211 of the sealing groove 21 is arranged obliquely upward at least in a portion where the inclined segment 211A is located.

Specifically, the inclined segment 211A forms the above inclined path segment, and the curved segment 211B forms the above curved path segment. In this case, the shape of the outer surface of the sealing plate 11 is provided to match the shape of the inner surface of the outer groove wall 211.

FIG. 5 shows a case that the inner surface of the outer groove wall 211 of the sealing groove 21 is parallel to the outer surface of the sealing plate 11, and the entire inner surface of the outer groove wall 211 is arranged obliquely upward. In this case, in a set vertical section, the outer sealant cavity 3 is inclined outwards from bottom to top. That is to say, the path for overflow through the outer sealant cavity 3 includes the inclined path segment, such that the length of the path of the sealant 8 flowing to reach the overflow portion 31 for overflow through the outer overflow portion 31 is greater, where the set vertical section is parallel to the width direction of the sealing groove 21.

FIG. 6 shows a case that the inner surface of the outer groove wall 211 of the sealing groove 21 includes a first protrusion-recessed structure, the outer surface of the sealing plate 11 includes a second protrusion-recessed structure, and the first protrusion-recessed structure matches the second protrusion-recessed structure in shape. Specifically, when the lower surface of the sealing plate 11 is fitted to the inner bottom face 213 of the sealing groove 21, the first protrusion-recessed structure matches the second protrusion-recessed structure. In this case, in the set vertical section, the outer sealant cavity 3 is of a curved structure. That is to say, the path for overflow through the outer sealant cavity 3 includes the curved path segment, such that the length of the path of the sealant 8 flowing to reach the outer overflow portion 31 for overflow through the outer overflow portion 31 is greater.

In the above embodiment, in one solution, the outer overflow portion 31 is flush with the inner overflow portion 41 in the up-down direction, or the outer overflow portion 31 is higher than the inner overflow portion 41 in the up-down direction.

As shown in FIG. 4, the outer overflow portion 31 being flush with the inner overflow portion 41 in the up-down direction, which facilitates the structural arrangement of the sealing groove 21, and prevents the outer overflow portion 31 and the inner overflow portion 41 from forming at different heights in the up-down direction. For example, the outer overflow portion 31 is embodied as a top face of the outer groove wall 211 of the sealing groove 21, and the inner overflow portion 41 is embodied as a top face of the inner groove wall 212 of the sealing groove 21, which facilitates forming of the structure of the sealing groove 21.

As shown in FIG. 2, the outer overflow portion 31 is higher than the inner overflow portion 41 in the up-down direction. In this case, in one aspect, the length of the path of the sealant 8 flowing to reach the outer overflow portion 31 for overflow through the outer overflow portion 31 of the outer sealant cavity 3 is increased to some extent, such that the resistance loss corresponding to the outer sealant cavity 3 is increased, thereby further reducing the possibility of the sealant 8 overflowing through the outer overflow portion 31. In another aspect, the volume of the outer sealant cavity 3 is increased to accommodate more sealant 8, such that even in cases that it is relatively difficult for the sealant 8 to overflow from the inner overflow portion 41 or most of the sealant 8 cannot overflow from the inner overflow portion 41, the excessive sealant 8 can still be accommodated by a portion of the outer sealant cavity 3 below the outer overflow portion 31 and above the inner overflow portion 41, thereby further reducing the possibility of the sealant 8 overflowing through the outer overflow portion 31. In this case, the outer overflow portion 31 may also be embodied as the top face of the outer groove wall 211 of the sealing groove 21, and the inner overflow portion 41 may also be embodied as the top face of the inner groove wall 212 of the sealing groove 21.

Certainly, in other embodiments, the outer overflow portion 31 may be a slot or a hole provided on the outer groove wall 211 of the sealing groove 21, and the inner overflow portion 41 may be a slot or a hole being provided on the inner groove wall 212 of the sealing groove 21, which are not described in detail herein.

In the above embodiments, in one solution, at least one of the sealing groove 21 and the sealing plate 11 is provided with a recessed structure 7.

Specifically, with the recessed structure 7, the capacity of the outer sealant cavity 3 or the inner sealant cavity 4 for accommodating the sealant 8 can be enhanced, so as to reduce the possibility of the overflow through the outer overflow portion 31.

Further, the recessed structure 7 includes at least one of a first recessed portion 71, a second recessed portion 72, a third recessed portion 73, a fourth recessed portion 74, and a fifth recessed portion.

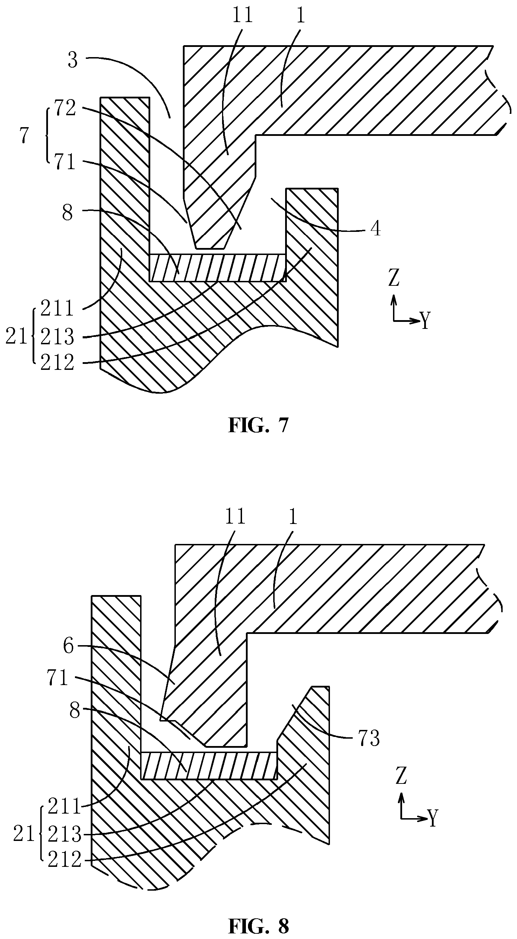

As shown in FIGS. 7 and 8, the first recessed portion 71 is provided at an outer edge of a lower end of the sealing plate 11. For example, the first recessed portion 71 is designed to be a triangular notch by chamfering.

As shown in FIG. 7, the second recessed portion 72 is provided at an inner edge of the lower end of the sealing plate 11. For example, the second recessed portion 72 is designed to be a triangular notch by chamfering.

As shown in FIG. 8, the third recessed portion 73 is provided on the inner groove wall 212 of the sealing groove 21.

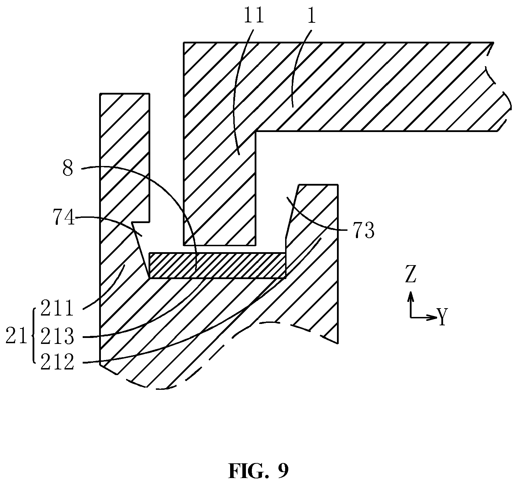

As shown in FIG. 9, the fourth recessed portion 74 is provided on the outer groove wall 211 of the sealing groove 21 (as shown in the drawing). Specifically, the fourth recessed portion 74 is a notch (for example, a triangular notch) provided on the inner surface of the outer groove wall 211.

In an embodiment, the recessed structure 7 extends along the extension direction of the sealing groove 21. For example, the recessed structure 7 extends such that two ends thereof are connected to each other. In this way, with the recessed structure 7, the capacity of the sealing groove 21 for accommodating the sealant 8 is significantly improved.

In the above embodiments, optionally, at least one of the sealing groove 21 and the sealing plate 11 is provided with a rough texture at a portion corresponding to the outer sealant cavity 3.

The rough texture may be provided in a way according to the prior art, to increase the resistance loss corresponding to the outer sealant cavity 3.

In the above embodiments, the insertion positioning structure may include a positioning rod and a positioning hole. For example, the upper housing 1 and the lower housing 2 are provided with the positioning rod and the positioning hole respectively, and the positioning rod and the positioning hole are connected by insertion. Alternatively, the upper housing 1 and the lower housing 2 are provided with two positioning holes respectively, and two ends of the positioning rod are connected to the two positioning holes respectively. When the sealed housing is used for mounting the circuit board assembly, the positioning rod may also be configured to position the circuit board assembly.

In an embodiment, at least one of the upper housing 1 and the lower housing 2 is provided with a filling hole used for filling an adhesive into the mounting cavity 5.

In this way, after the upper housing 1, the lower housing 2 and the component inside the mounting cavity 5 are mounted, the sealant 8 in the sealing groove 21 seals a joint face between the upper housing 1 and the lower housing 2. Then, the adhesive is filled into the mounting cavity through the filling hole, so as to protect the component inside the mounting cavity 5, which ensures the waterproof and dustproof performance of the inverter, for example, and reduce the possibility of overflow at the joint face when the adhesive is being filled.

The upper housing 1 or the lower housing 2 may be provided with a mounting hole for mounting a cable assembly 9.

In a second aspect of the present application, an inverter is provided, including the sealed housing according to the above embodiments.

In a third aspect of the present application, an electric power system is provided, including the inverter according to the above embodiment, or the sealed housing according to the above embodiments. For example, the electric power system may be a photovoltaic power system.

## Claims

1. A sealed housing, comprising an upper housing (1) and a lower housing (2), wherein
the lower housing (2) is provided with a sealing groove (21) extending along a peripheral direction of the lower housing (2), and the upper housing (1) is provided with a sealing plate (11) corresponding to the sealing groove (21);
a sealant (8) is provided inside the sealing groove (21), and the sealing plate (11) extends into the sealant (8);
an outer sealant cavity (3) and an inner sealant cavity (4) are formed at both sides of the sealing plate (11) respectively inside the sealing groove (21), and a mounting cavity (5) is defined by the upper housing (1) and the lower housing (2);
the outer sealant cavity (3) is provided with an outer overflow portion (31), and the inner sealant cavity (4) is provided with an inner overflow portion (41); and
the sealing groove (21) and the sealing plate (11) are configured to make a resistance loss corresponding to the outer sealant cavity (3) be higher than a resistance loss corresponding to the inner sealant cavity (4), wherein the resistance loss refers to mechanical energy consumed by the sealant (8) per unit weight when flowing to reach the corresponding overflow portion through the corresponding sealant cavity.

2. The sealed housing according to claim 1, wherein a minimum size of the outer sealant cavity (3) in a width direction of the sealing groove (21) is smaller than a minimum size of the inner sealant cavity (4) in the width direction of the sealing groove (21).

3. The sealed housing according to claim 2, wherein at least one of the sealing groove (21) and the sealing plate (11) is provided with a sealant blocking structure (6) at the outer sealant cavity (3).

4. The sealed housing according to claim 3, wherein
the sealant blocking structure (6) comprises a height-set section (61), and in the height-set section (61), a surface of the sealant blocking structure (6) in the width direction of the sealing groove (21) is arranged obliquely upward; and/or
when a lower surface of the sealing plate (11) is fitted to an inner bottom face (213) of the sealing groove (21), a lower end of the sealant blocking structure (6) is spaced apart from the inner bottom face (213) of the sealing groove (21); and/or
when the lower surface of the sealing plate (11) is fitted to the inner bottom face (213) of the sealing groove (21), an upper end of the sealant blocking structure (6) is spaced apart from the outer overflow portion (31) in an up-down direction.

5. The sealed housing according to claim 1, wherein a length of a path along which the sealant (8) flows to reach the outer overflow portion (31) for overflow through the outer overflow portion (31) of the outer sealant cavity (3) is greater than or equal to a length of a path along which the sealant (8) flows to reach the inner overflow portion (41) for overflow through the inner overflow portion (41) of the inner sealant cavity (4).

6. The sealed housing according to claim 5, wherein the path, along which the sealant (8) flows to reach the outer overflow portion (31) for overflow through the outer overflow portion (31) of the outer sealant cavity (3), comprises at least one of an inclined path segment and a curved path segment.

7. The sealed housing according to claim 6, wherein an inner surface of an outer groove wall (211) of the sealing groove (21) comprises at least one of an inclined segment (211A) and a curved segment (211B) in an up-down direction; in a case that the inclined segment (211A) is provided, the inner surface of the outer groove wall (211) of the sealing groove (21) is arranged obliquely upward at least in a portion where the inclined segment (211A) is located.

8. The sealed housing according to any one of claims 1 to 7, wherein
the outer overflow portion (31) is higher than or flush with the inner overflow portion (41) in an up-down direction; and/or
a top face of an outer groove wall (211) of the sealing groove (21) forms the outer overflow portion (31); and/or
a top face of an inner groove wall (212) of the sealing groove (21) forms the inner overflow portion (41).

9. The sealed housing according to any one of claims 1 to 7, wherein at least one of the sealing groove (21) and the sealing plate (11) is provided with a recessed structure (7).

10. The sealed housing according to claim 9, wherein
the recessed structure (7) comprises at least one of a first recessed portion (71), a second recessed portion (72), a third recessed portion (73), and a fourth recessed portion (74); and wherein the first recessed portion (71) is provided at an outer edge of a lower end of the sealing plate (11), the second recessed portion (72) is provided at an inner edge of the lower end of the sealing plate (11), the third recessed portion (73) is provided on an inner groove wall (212) of the sealing groove (21), and the fourth recessed portion (74) is provided on an outer groove wall (211) of the sealing groove (21); and/or
the recessed structure (7) extends along an extension direction of the sealing groove (21).

11. The sealed housing according to any one of claims 1 to 7, wherein
at least one of the sealing groove (21) and the sealing plate (11) is provided with a rough texture at a portion corresponding to the outer sealant cavity (3); and/or
the sealed housing further comprises an insertion positioning structure, and the upper housing (1) and the lower housing (2) are positionally connected through the insertion positioning structure; and/or
at least one of the upper housing (1) and the lower housing (2) is provided with a filling hole through which an adhesive is filled into the mounting cavity (5).

12. An inverter, comprising the sealed housing according to any one of claims 1 to 11.

13. An electric power system, comprising the sealed housing according to any one of claims 1 to 11, or the inverter according to claim 12.

## Patentansprüche

1. Abgedichtetes Gehäuse, umfassend ein oberes Gehäuse (1) und ein unteres Gehäuse (2), wobei
das untere Gehäuse (2) mit einer Dichtungsnut (21) bereitgestellt ist, die sich entlang einer Umfangsrichtung des unteren Gehäuses (2) erstreckt, und das obere Gehäuse (1) mit einer Dichtplatte (11) bereitgestellt ist, die der Dichtungsnut (21) entspricht;
ein Dichtmittel (8) innerhalb der Dichtungsnut (21) bereitgestellt ist, und die Dichtplatte (11) sich in das Dichtmittel (8) erstreckt;
ein äußerer Dichtmittelhohlraum (3) und ein innerer Dichtmittelhohlraum (4) jeweils an beiden Seiten der Dichtplatte (11) innerhalb der Dichtungsnut (21) gebildet sind, und ein Montagehohlraum (5) durch das obere Gehäuse (1) und das untere Gehäuse (2) definiert ist;
der äußere Dichtmittelhohlraum (3) mit einem äußeren Überlaufbereich (31) bereitgestellt ist, und der innere Dichtmittelhohlraum (4) mit einem inneren Überlaufbereich (41) bereitgestellt ist; und
die Dichtungsnut (21) und die Dichtplatte (11) so ausgebildet sind, dass ein dem äußeren Dichtmittelhohlraum (3) entsprechender Widerstandsverlust höher ist als ein dem inneren Dichtmittelhohlraum (4) entsprechender Widerstandsverlust, wobei sich der Widerstandsverlust auf mechanische Energie bezieht, die durch das Dichtmittel (8) pro Gewichtseinheit verbraucht wird, wenn es fließt, um den entsprechenden Überlaufbereich durch den entsprechenden Dichtmittelhohlraum zu erreichen.

2. Abgedichtetes Gehäuse nach Anspruch 1, wobei eine Mindestgröße des äußeren Dichtmittelhohlraums (3) in einer Breitenrichtung der Dichtungsnut (21) kleiner ist als eine Mindestgröße des inneren Dichtmittelhohlraums (4) in der Breitenrichtung der Dichtungsnut (21).

3. Abgedichtetes Gehäuse nach Anspruch 2, wobei mindestens eines von der Dichtungsnut (21) und der Dichtplatte (11) an dem äußeren Dichtmittelhohlraum (3) mit einer Dichtmittel-Sperrstruktur (6) bereitgestellt ist.

4. Abgedichtetes Gehäuse nach Anspruch 3, wobei
die Dichtmittel-Sperrstruktur (6) einen höheneingestellten Abschnitt (61) umfasst, und in dem höheneingestellten Abschnitt (61) eine Oberfläche der Dichtmittel-Sperrstruktur (6) in der Breitenrichtung der Dichtungsnut (21) schräg nach oben angeordnet ist; und/oder
wenn eine untere Oberfläche der Dichtplatte (11) an einer inneren Bodenfläche (213) der Dichtungsnut (21) eingepasst ist, ein unteres Ende der Dichtmittel-Sperrstruktur (6) von der inneren Bodenfläche (213) der Dichtungsnut (21) beabstandet ist; und/oder
wenn die untere Oberfläche der Dichtplatte (11) an der inneren Bodenfläche (213) der Dichtungsnut (21) eingepasst ist, ein oberes Ende der Dichtmittel-Sperrstruktur (6) in einer Oben-unten-Richtung von dem äußeren Überlaufbereich (31) beabstandet ist.

5. Abgedichtetes Gehäuse nach Anspruch 1, wobei eine Länge eines Pfads, entlang dem das Dichtmittel (8) fließt, um den äußeren Überlaufbereich (31) zum Überlaufen durch den äußeren Überlaufbereich (31) des äußeren Dichtmittelhohlraums (3) zu erreichen, größer oder gleich einer Länge eines Pfads ist, entlang dem das Dichtmittel (8) fließt, um den inneren Überlaufbereich (41) zum Überlaufen durch den inneren Überlaufbereich (41) des inneren Dichtmittelhohlraums (4) zu erreichen.

6. Abgedichtetes Gehäuse nach Anspruch 5, wobei der Pfad, entlang dem das Dichtmittel (8) fließt, um den äußeren Überlaufbereich (31) zum Überlaufen durch den äußeren Überlaufbereich (31) des äußeren Dichtmittelhohlraums (3) zu erreichen, mindestens eines von einem schrägen Pfadsegment und einem gekrümmten Pfadsegment umfasst.

7. Abgedichtetes Gehäuse nach Anspruch 6, wobei eine Innenfläche einer äußeren Nutwand (211) der Dichtungsnut (21) mindestens eines von einem schrägen Segment (211A) und einem gekrümmten Segment (211B) in einer Oben-unten-Richtung umfasst; für den Fall, dass das schräge Segment (211A) bereitgestellt ist, ist die Innenfläche der äußeren Nutwand (211) der Dichtungsnut (21) zumindest in einem Bereich, in dem sich das schräge Segment (211A) befindet, schräg nach oben angeordnet.

8. Abgedichtetes Gehäuse nach einem der Ansprüche 1 bis 7, wobei
der äußere Überlaufbereich (31) in einer Oben-unten-Richtung höher als der innere Überlaufbereich (41) oder bündig mit diesem ist; und/oder
eine obere Fläche einer äußeren Nutwand (211) der Dichtungsnut (21) den äußeren Überlaufbereich (31) bildet; und/oder
eine obere Fläche einer inneren Nutwand (212) der Dichtungsnut (21) den inneren Überlaufbereich (41) bildet.

9. Abgedichtetes Gehäuse nach einem der Ansprüche 1 bis 7, wobei mindestens eines von der Dichtungsnut (21) und der Dichtplatte (11) mit einer Vertiefungsstruktur (7) bereitgestellt ist.

10. Abgedichtetes Gehäuse nach Anspruch 9, wobei
die Vertiefungsstruktur (7) mindestens einen von einem ersten Vertiefungsbereich (71), einem zweiten Vertiefungsbereich (72), einem dritten Vertiefungsbereich (73) und einem vierten Vertiefungsbereich (74) umfasst; und wobei der erste Vertiefungsbereich (71) an einer äußeren Kante eines unteren Endes der Dichtplatte (11) bereitgestellt ist, der zweite Vertiefungsbereich (72) an einer inneren Kante des unteren Endes der Dichtplatte (11) bereitgestellt ist, der dritte Vertiefungsbereich (73) an einer inneren Nutwand (212) der Dichtungsnut (21) bereitgestellt ist und der vierte Vertiefungsbereich (74) an einer äußeren Nutwand (211) der Dichtungsnut (21) bereitgestellt ist; und/oder
die Vertiefungsstruktur (7) sich entlang einer Erstreckungsrichtung der Dichtungsnut (21) erstreckt.

11. Abgedichtetes Gehäuse nach einem der Ansprüche 1 bis 7, wobei
mindestens eines von der Dichtungsnut (21) und der Dichtplatte (11) an einem dem äußeren Dichtmittelhohlraum (3) entsprechenden Bereich mit einer rauen Textur bereitgestellt ist; und/oder
das abgedichtete Gehäuse weiter eine Einführ-Positionierstruktur umfasst, und das obere Gehäuse (1) und das untere Gehäuse (2) durch die Einführ-Positionierstruktur positionell verbunden sind; und/oder
mindestens eines von dem oberen Gehäuse (1) und dem unteren Gehäuse (2) mit einer Einfüllöffnung bereitgestellt ist, durch die ein Klebstoff in den Montagehohlraum (5) eingefüllt wird.

12. Wechselrichter, umfassend das abgedichtete Gehäuse nach einem der Ansprüche 1 bis 11.

13. Elektrisches Stromversorgungssystem, umfassend das abgedichtete Gehäuse nach einem der Ansprüche 1 bis 11, oder den Wechselrichter nach Anspruch 12.

## Revendications

1. Boîtier étanche, comprenant un boîtier supérieur (1) et un boîtier inférieur (2), dans lequel
le boîtier inférieur (2) est muni d'une rainure d'étanchéité (21) s'étendant le long d'une direction périphérique du boîtier inférieur (2), et le boîtier supérieur (1) est muni d'une plaque d'étanchéité (11) correspondant à la rainure d'étanchéité (21) ;
un produit d'étanchéité (8) est disposé à l'intérieur de la rainure d'étanchéité (21), et la plaque d'étanchéité (11) s'étend dans le produit d'étanchéité (8) ;
une cavité externe (3) de produit d'étanchéité et une cavité interne (4) de produit d'étanchéité sont formées respectivement des deux côtés de la plaque d'étanchéité (11) à l'intérieur de la rainure d'étanchéité (21), et une cavité de montage (5) est définie par le boîtier supérieur (1) et le boîtier inférieur (2) ;
la cavité externe (3) de produit d'étanchéité est munie d'une partie de sur-verse externe (31), et la cavité interne (4) de produit d'étanchéité est munie d'une partie de sur-verse interne (41) ; et
la rainure d'étanchéité (21) et la plaque d'étanchéité (11) sont configurées de manière à faire en sorte qu'une perte de résistance correspondant à la cavité externe (3) de produit d'étanchéité soit supérieure à une perte de résistance correspondant à la cavité interne (4) de produit d'étanchéité, dans lequel la perte de résistance désigne l'énergie mécanique consommée par le produit d'étanchéité (8) par unité de poids lorsqu'il s'écoule pour atteindre la partie de sur-verse correspondante à travers la cavité de produit d'étanchéité correspondante.

2. Boîtier étanche selon la revendication 1, dans lequel une taille minimale de la cavité externe (3) de produit d'étanchéité dans une direction de largeur de la rainure d'étanchéité (21) est inférieure à une taille minimale de la cavité interne (4) de produit d'étanchéité dans la direction de largeur de la rainure d'étanchéité (21).

3. Boîtier étanche selon la revendication 2, dans lequel au moins l'une de la rainure d'étanchéité (21) et de la plaque d'étanchéité (11) est munie d'une structure (6) de blocage de produit d'étanchéité au niveau de la cavité externe (3) de produit d'étanchéité.

4. Boîtier étanche selon la revendication 3, dans lequel
la structure (6) de blocage de produit d'étanchéité comprend une section (61) de réglage de hauteur, et, dans la section (61) de réglage de hauteur, une surface de la structure (6) de blocage de produit d'étanchéité dans la direction de largeur de la rainure d'étanchéité (21) est agencée obliquement vers le haut ; et/ou
lorsqu'une surface inférieure de la plaque d'étanchéité (11) est ajustée à une face inférieure interne (213) de la rainure d'étanchéité (21), une extrémité inférieure de la structure (6) de blocage de produit d'étanchéité est espacée de la face inférieure interne (213) de la rainure d'étanchéité (21) ; et/ou
lorsque la surface inférieure de la plaque d'étanchéité (11) est ajustée à la face inférieure interne (213) de la rainure d'étanchéité (21), une extrémité supérieure de la structure (6) de blocage de produit d'étanchéité est espacée de la partie de sur-verse externe (31) dans une direction haut-bas.

5. Boîtier étanche selon la revendication 1, dans lequel une longueur d'un trajet le long duquel le produit d'étanchéité (8) s'écoule pour atteindre la partie de sur-verse externe (31) pour une sur-verse à travers la partie de sur-verse externe (31) de la cavité externe (3) de produit d'étanchéité est supérieure ou égale à une longueur d'un trajet le long duquel le produit d'étanchéité (8) s'écoule pour atteindre la partie de sur-verse interne (41) pour une sur-verse à travers la partie de sur-verse interne (41) de la cavité interne (4) de produit d'étanchéité.

6. Boîtier étanche selon la revendication 5, dans lequel le trajet, le long duquel le produit d'étanchéité (8) s'écoule pour atteindre la partie de sur-verse externe (31) pour une sur-verse à travers la partie de sur-verse externe (31) de la cavité externe (3) de produit d'étanchéité, comprend au moins l'un d'un segment de trajet incliné et d'un segment de trajet courbe.

7. Boîtier étanche selon la revendication 6, dans lequel une surface interne d'une paroi (211) de rainure externe de la rainure d'étanchéité (21) comprend au moins l'un d'un segment incliné (211A) et d'un segment courbe (211B) dans une direction haut-bas ; dans un cas où le segment incliné (211A) est prévu, la surface interne de la paroi (211) de rainure externe de la rainure d'étanchéité (21) est agencée obliquement vers le haut au moins dans une partie où le segment incliné (211A) est situé.

8. Boîtier étanche selon l'une quelconque des revendications 1 à 7, dans lequel
la partie de sur-verse externe (31) est plus haute ou au même niveau que la partie de sur-verse interne (41) dans une direction haut-bas ; et/ou
une face supérieure d'une paroi (211) de rainure externe de la rainure d'étanchéité (21) forme la partie de sur-verse externe (31) ; et/ou
une face supérieure d'une paroi (212) de rainure interne de la rainure d'étanchéité (21) forme la partie de sur-verse interne (41).

9. Boîtier étanche selon l'une quelconque des revendications 1 à 7, dans lequel au moins l'une de la rainure d'étanchéité (21) et de la plaque d'étanchéité (11) est munie d'une structure évidée (7).

10. Boîtier étanche selon la revendication 9, dans lequel
la structure évidée (7) comprend au moins l'une d'une première partie évidée (71), d'une deuxième partie évidée (72), d'une troisième partie évidée (73) et d'une quatrième partie évidée (74) ; et dans lequel la première partie évidée (71) est prévue au niveau d'un bord externe d'une extrémité inférieure de la plaque d'étanchéité (11), la deuxième partie évidée (72) est prévue au niveau d'un bord interne de l'extrémité inférieure de la plaque d'étanchéité (11), la troisième partie évidée (73) est prévue sur une paroi (212) de rainure interne de la rainure d'étanchéité (21), et la quatrième partie évidée (74) est prévue sur une paroi (211) de rainure externe de la rainure d'étanchéité (21) ; et/ou
la structure évidée (7) s'étend le long d'une direction d'extension de la rainure d'étanchéité (21).

11. Boîtier étanche selon l'une quelconque des revendications 1 à 7, dans lequel
au moins l'une de la rainure d'étanchéité (21) et de la plaque d'étanchéité (11) est munie d'une texture rugueuse au niveau d'une partie correspondant à la cavité externe (3) de produit d'étanchéité ; et/ou
le boîtier étanche comprend en outre une structure de positionnement par insertion, et le boîtier supérieur (1) et le boîtier inférieur (2) sont reliés en position à travers la structure de positionnement par insertion ; et/ou
au moins l'un du boîtier supérieur (1) et du boîtier inférieur (2) est muni d'un orifice de remplissage à travers lequel un adhésif est injecté dans la cavité de montage (5).

12. Onduleur, comprenant le boîtier étanche selon l'une quelconque des revendications 1 à 11.

13. Système d'alimentation électrique, comprenant le boîtier étanche selon l'une quelconque des revendications 1 à 11, ou l'onduleur selon la revendication 12.
